# EUROPEAN PATENT APPLICATION

(11) **EP 4 718 428 A1**
(43) Date of publication of application: **01.04.2026**
(21) Application number: 25204582.8
(22) Date of filing: 25.09.2025
(51) Int. Cl.: G09F 27/00, H02S 40/00, H10F 39/90, H10F 55/00

(54) **SELF-POWERED DISPLAY DEVICE**

(30) Priority: 26.09.2024 US 202463699165 P; 09.09.2025 TW 114134485
(71) Applicant: Iris Optronics Co., Ltd., Tainan City 711010 (TW)
(72) Inventor: CHANG, Yu Kun, 310021 Zhudong Township (TW); CHEN, Chih Wei, 310021 Zhudong Township (TW); LIAO, Chi Chang, 700022 Tainan City (TW)
(74) Representative: Studio Torta S.p.A.

(57) **Abstract**

A self-powered display device (100) includes a solar module (110) and a display panel (120). The solar module (110) has a first surface (S1) and a second surface (S2) opposite to each other, and includes a polymer layer (111), a plurality of solar cells (112) and a plurality of opaque patterns (113). The solar cells (112) are electrically connected to each other and embedded in the polymer layer (111) at intervals. The opaque patterns (113) are embedded in the polymer layer (111), wherein projections of the opaque patterns (113) on the first surface (S1) are respectively located between projections of the solar cells (112) on the first surface. The display panel (120) is disposed on the first surface (S1) of the solar module. The solar module (110) is configured to receive the light from the first surface and the second surface.

## Description

### BACKGROUND

### Technical Field

The present disclosure relates to a display device. More particularly, the present disclosure relates to a self-powered display device.

### Description of Related Art

Although integrating solar cells into outdoor displays can provide a small amount of power, it cannot meet the power consumption requirements of displays used in high-frequency refresh applications. Moreover, outdoor displays are generally used in an upright orientation, resulting in less efficient energy harvesting compared to commonly used flat-mounted solar cells.

In addition, most of the outdoor displays adopt transflective displays (transflective E-paper displays). When sunlight shines on the solar cells embedded in such displays, most of the light is reflected to form images, and only about 10%-30% of the light can be absorbed by the solar cells located behind the display and converted into electricity. As a result, the transflective displays is unable to supply power self-sufficiently during high-frequency image refresh operations.

Therefore, the recent market is short of the self-powered display device with good energy harvesting performance, so relevant industries are all looking for solutions.

### SUMMARY

The present disclosure provides a self-powered display device which includes a solar module and a display panel. The solar module has a first surface and a second surface opposite to each other, and includes a polymer layer, a plurality of solar cells and a plurality of opaque patterns. The solar cells are electrically connected to each other and embedded in the polymer layer at intervals. The opaque patterns are embedded in the polymer layer, wherein projections of the opaque patterns on the first surface are respectively located between projections of the solar cells on the first surface. The display panel is disposed on the first surface of the solar module. The solar module is configured to receive the light from the first surface and the second surface.

According to the self-powered display device of the foregoing aspect, a surface of the opaque patterns away from the solar cells is coplanar with a surface of the polymer layer adjacent to the first surface.

According to the self-powered display device of the foregoing aspect, the self-powered display device further includes an optical adhesive layer. The optical adhesive layer is disposed between the solar module and the display panel.

According to the self-powered display device of the foregoing aspect, the solar module further includes two substrates, and the two substrates are respectively disposed on two surfaces of the polymer layer.

According to the self-powered display device of the foregoing aspect, the self-powered display device further includes a case. The case is disposed on an outer periphery of the display panel. A size of the case is larger than an outer periphery of the solar module.

According to the self-powered display device of the foregoing aspect, the case includes a plurality of auxiliary solar cells, and the auxiliary solar cells are electrically connected to each other and spaced apart in the case.

According to the self-powered display device of the foregoing aspect, an area of each of the auxiliary solar cells is smaller than an area of each of the solar cells.

According to the self-powered display device of the foregoing aspect, the self-powered display device further includes a maximum power point tracking controller. The maximum power point tracking controller is electrically connected to the solar module.

The present disclosure provides another self-powered display device which includes a first solar module, a second solar module and a display panel. The first solar module has a first surface and a second surface opposite to each other, and includes a plurality of opaque patterns. The second solar module is disposed on the second surface of the first solar module, and has a third surface and a fourth surface opposite to each other, wherein the third surface is attached to the second surface of the first solar module. The display panel is disposed on the first surface of the first solar module. The first solar module is configured to receive the light from the first surface, and the second solar module is configured to receive the light from the fourth surface, and each of the first solar module or the second solar module includes a polymer layer and a plurality of solar cells. The solar cells are electrically connected to each other and embedded in the polymer layer at intervals. The opaque patterns of the first solar module are embedded in the polymer layer of the first solar module, and projections of the opaque patterns on the first surface are respectively located between projections of the solar cells on the first surface.

According to the self-powered display device of the foregoing aspect, a surface of the opaque patterns away from the solar cells is coplanar with a surface of the polymer layer adjacent to the first surface.

According to the self-powered display device of the foregoing aspect, the self-powered display device further includes an optical adhesive layer. The optical adhesive layer is disposed between the first solar module and the display panel.

According to the self-powered display device of the foregoing aspect, each of the first solar module or the second solar module further includes two substrates, and the two substrates are respectively disposed on two surfaces of the polymer layer.

According to the self-powered display device of the foregoing aspect, the self-powered display device further includes a maximum power point tracking controller and a switch. The maximum power point tracking controller is electrically connected to the first solar module and the second solar module. The switch is electrically connected to the first solar module, the second solar module and the maximum power point tracking controller. The maximum power point tracking controller controls the switch to switch according to light intensities or power outputs of the first solar module and the second solar module.

According to the self-powered display device of the foregoing aspect, the maximum power point tracking controller compares the light intensities or the power outputs of the first solar module and the second solar module, and controls the switch to switch to one with higher light intensity or higher power output to the maximum power point tracking controller.

### BRIEF DESCRIPTION OF THE DRAWINGS

The present disclosure can be more fully understood by reading the following detailed description of the embodiment, with reference made to the accompanying drawings as follows:
Fig. 1 is a schematic view of a self-powered display device according to the 1st embodiment of the present disclosure.
Fig. 2 is a cross-sectional schematic view of the self-powered display device according to the 1st embodiment in Fig. 1.
Fig. 3 is a cross-sectional schematic view of a self-powered display device according to the 2nd embodiment of the present disclosure.

### DETAILED DESCRIPTION

The embodiment will be described with the drawings. For clarity, some practical details will be described below. However, it should be noted that the present disclosure should not be limited by the practical details, that is, in some embodiment, the practical details is unnecessary. In addition, for simplifying the drawings, some conventional structures and elements will be simply illustrated, and repeated elements may be represented by the same labels.

In addition, the terms first, second, third, etc. are used herein to describe various elements or components, these elements or components should not be limited by these terms. Consequently, a first element or component discussed below could be termed a second element or component.

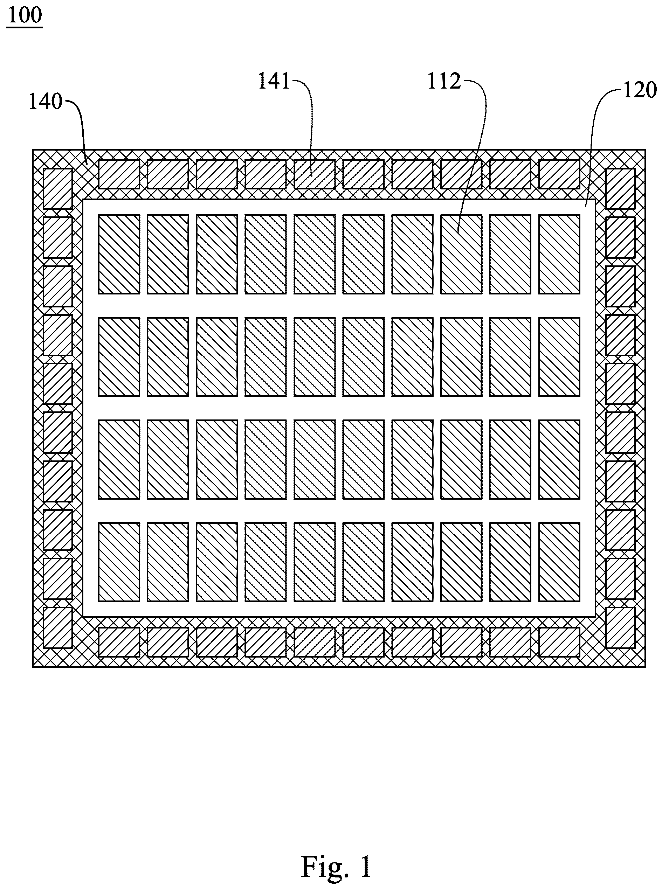

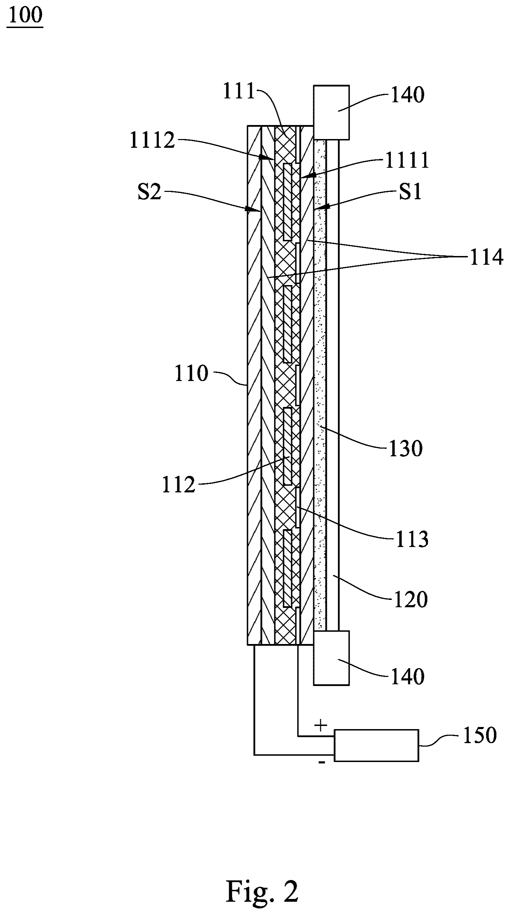

Fig. 1 is a schematic view of a self-powered display device according to the 1st embodiment of the present disclosure. Fig. 2 is a cross-sectional schematic view of the self-powered display device according to the 1st embodiment in Fig. 1. According to Fig. 1 and Fig. 2, the self-powered display device 100 includes a solar module 110, a display panel 120 and an optical adhesive layer 130. The solar module 110 has a first surface S1 and a second surface S2 opposite to each other, the display panel 120 is disposed on the first surface S1 of the solar module 110. The optical adhesive layer 130 is disposed between the solar module 110 and the display panel 120. The solar module 110 is configured to receive the light from the first surface S1 and the second surface S2. In the 1st embodiment, the display panel 120 can be a transflective E-paper displays panel or a cholesteric liquid crystal display panel, but the present disclosure is not limited thereto.

The solar module 110 includes a polymer layer 111, a plurality of solar cells 112, a plurality of opaque patterns 113 and two substrates 114. The solar cells 112 and the opaque patterns 113 are embedded in the polymer layer 111, and the two substrates 114 are respectively disposed on the surface 1111 and the surface 1112 of the polymer layer 111.

The solar cells 112 are electrically connected to each other and embedded in the polymer layer 111 at intervals, and the opaque patterns 113 are also embedded in the polymer layer 111. In the 1st embodiment, the polymer layer 111 can be ethylene-vinyl acetate copolymer (EVA), polyoxyethylene (POE), or Tedlar film; the solar cells 112 can be silicon wafer solar cells or solar cells with a double-sided absorption composite material structure for power generation. For example, the solar cells with double-sided absorption photovoltaic composite structure are made of a combination of silicon wafers stacked with perovskite solar cells, a combination of silicon wafers stacked with amorphous silicon (a-Si) solar cells, or a combination of silicon wafers stacked with organic photovoltaics (OPV); the opaque patterns 113 can be made of printing ink, a patterned backplane, or tape; the substrates 114 can be a transparent packaging material such as tempered glass, polyethylene terephthalate (PET), or ethylene tetrafluoroethylene (ETFE), but the present disclosure is not limited thereto.

Specifically, in the formation of the solar module 110, solar cells 112 and the opaque patterns 113 are first placed within the polymer layer 111. The polymer layer 111 is then covered with the substrates 114. After the solar module 110 is assembled, it is bonded to the display panel 120 via the optical adhesive layer 130.

According to Fig. 2, projections of the opaque patterns 113 on the first surface S1 are respectively located between projections of the solar cells 112 on the first surface S1. A surface of the opaque patterns 113 away from the solar cells 112 is coplanar with a surface 1111 of the polymer layer 111 adjacent to the first surface S1.

In detail, each of the opaque patterns 113 is disposed between each pair of adjacent solar cells 112. Therefore, it eliminates light leakage through the gaps between the solar cells 112, thus preventing uneven display on the display panel 120 and improving the contrast of the display panel 120. Moreover, compared to self-powered displays that can only receive light from a single surface due to the sun's orbit, the solar module 110 with dual-sided can extend the average power generation time (for example, receiving light from the first surface S1 in the morning and from the second surface S2 in the afternoon), thereby increasing the energy harvesting efficiency of the self-powered display device 100.

Furthermore, the self-powered display device 100 further includes a case 140 and a maximum power point tracking (MPPT) controller 150. The case 140 is disposed on an outer periphery of the display panel 120 (as shown in Fig. 2). A size of the case 140 is larger than the outer periphery of the solar module 110 (as shown in Fig. 1). The MPPT controller 150 is electrically connected to the solar module 110 and is configured to continuously monitor the voltage and current output by the solar module 110 and dynamically adjust its operating point to ensure that the solar module 110 can output maximum power under various environmental conditions.

The case 140 includes a plurality of auxiliary solar cells 141. The auxiliary solar cells 141 are electrically connected to each other and spaced apart in the case 140. The area of each of the auxiliary solar cells 141 is smaller than the area of each of the solar cells 112. In the 1st embodiment, the auxiliary solar cells 141 can also be silicon wafer solar cells or solar cells with a double-sided absorption composite material structure for power generation, but the present disclosure is not limited thereto.

It should be noted that, since the solar cells 112 in the solar module 110 are not exposed externally, the solar cells 112 can only absorb one-half to one-fourth of the sunlight for power generation, and thus their maximum power current is limited to one-half to one-fourth of that of the original solar cells 112. When the area of the auxiliary solar cells 141, which are exposed externally on the case 140, is one-half to one-fourth that of the solar cells 112, all of the solar cells 112 and the auxiliary solar cells 141 can be connected in series and operated using single MPPT controller 150 to track and generate maximum power.

Therefore, by adding the auxiliary solar cells 141 to the case 140, the energy harvesting area of the solar module 110 can be increased.

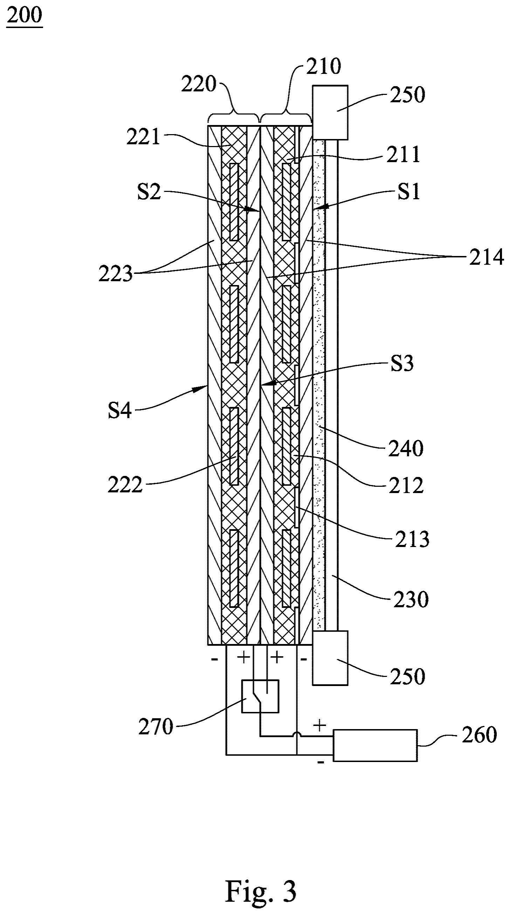

Fig. 3 is a cross-sectional schematic view of a self-powered display device according to the 2nd embodiment of the present disclosure. According to Fig. 3, the self-powered display device 200 includes a first solar module 210, a second solar module 220, a display panel 230 and an optical adhesive layer 240. The first solar module 210 has a first surface S1 and a second surface S2 opposite to each other, the second solar module 220 is disposed on the second surface S2 of the first solar module 210, the display panel 230 is disposed on the first surface S1 of the first solar module 210. The second solar module 220 has a third surface S3 and a fourth surface S4 opposite to each other, the third surface S3 is attached to the second surface S2 of the first solar module 210. The optical adhesive layer 240 is disposed between the first solar module 210 and the display panel 230. The first solar module 210 is configured to receive the light from the first surface S1, and the second solar module 220 is configured to receive the light from the fourth surface S4. In the 2nd embodiment, the display panel 230 is the same as the display panel 120 in the 1st embodiment, and will not described again herein.

The first solar module 210 includes a polymer layer 211, a plurality of solar cells 212, a plurality of opaque patterns 213 and two substrates 214. The second solar module 220 includes a polymer layer 221, a plurality of solar cells 222 and two substrates 223. The solar cells 212 and the opaque patterns 213 of the first solar module 210 are embedded in the polymer layer 211 of the first solar module 210, and the two substrates 214 are respectively disposed on two surfaces of the polymer layer 211. The solar cells 222 of the second solar module 220 are embedded in the polymer layer 221 of the second solar module 220, and the two substrates 223 are respectively disposed on two surfaces of the polymer layer 221.

The solar cells 212 of the first solar module 210 are electrically connected to each other and embedded in the polymer layer 211 at intervals, and the solar cells 222 of the second solar module 220 are electrically connected to each other and embedded in the polymer layer 221 at intervals. The positions of the solar cells 212 of the first solar module 210 correspond to the positions of the solar cells 222 of the second solar module 220.

It should be noted that, in the 2nd embodiment, the polymer layer 211 and the polymer layer 221 are the same as the polymer layer 111 of the 1st embodiment, the solar cells 212 and the solar cells 222 are the same as the solar cells 112 of the 1st embodiment, the opaque patterns 213 are the same as the opaque patterns 113 of the 1st embodiment, and the substrates 214 and the substrates 223 are the same as the substrate 114 of the 1st embodiment, and will not described again herein.

Projections of the opaque patterns 213 on the first surface S1 are respectively located between projections of the solar cells 212 and the solar cells 222 on the first surface S1. A surface of the opaque patterns 213 away from the solar cells 212 is coplanar with a surface of the polymer layer 211 adjacent to the first surface S1.

Therefore, by arranging the opaque patterns 213 in the gaps between each of the solar cells 212 and each of the solar cells 222, it is favorable for preventing uneven display on the display panel 230 and improving the contrast of the display panel 230.

Furthermore, the self-powered display device 200 further includes a case 250, a MPPT controller 260 and a switch 270. The case 250 is disposed on an outer periphery of the display panel 230. The MPPT controller 260 is electrically connected to the first solar module 210 and the second solar module 220. The switch 270 is electrically connected to the first solar module 210, the second solar module 220 and the MPPT controller 260.

The MPPT controller 260 controls the switch 270 to switch according to light intensities or power outputs of the first solar module 210 and the second solar module 220. In detail, the MPPT controller 260 compares the light intensity of the first solar module 210 and the light intensity of the second solar module 220 or compares the power output of the first solar module 210 and the power output of the second solar module 220, and controls the switch 270 to switch to the one with higher light intensity or higher power output to the MPPT controller 260.

Therefore, by providing the first solar module 210 and the second solar module 220 that receive light in opposite directions, the self-powered display device 200 can be switched to a higher output in real time according to the light intensities or the power outputs, and further increasing the energy harvesting time of the self-powered display device 200 and improving the charging effect.

According to the aforementioned examples, the self-powered display device of the present disclosure has at least the following advantages. First, the opaque patterns can be used to eliminate light leakage through the gaps between the solar cells, prevent uneven display on the display panel, and improve the contrast of the display panel. Second, by adding the auxiliary solar cells to the case, the energy harvesting area of the solar module can be increased. Third, the first solar module and the second solar module that collect light in opposite directions, can increase the energy harvesting time of the self-powered display device.

## Claims

1. A self-powered display device (100), **characterized in** comprising:
a solar module (110) having a first surface (S1) and a second surface (S2) opposite to each other, and comprising:
a polymer layer (111);
a plurality of solar cells (112) electrically connected to each other and embedded in the polymer layer (111) at intervals; and
a plurality of opaque patterns (113) embedded in the polymer layer (111), wherein projections of the opaque patterns (113) on the first surface (S1) are respectively located between projections of the solar cells (112) on the first surface (S1); and
a display panel (120) disposed on the first surface (S1) of the solar module (110);
wherein, the solar module (110) is configured to receive the light from the first surface (S1) and the second surface (S2).

2. The self-powered display device (100) of claim 1, wherein a surface of the opaque patterns (113) away from the solar cells (112) is coplanar with a surface of the polymer layer (111) adjacent to the first surface (S1).

3. The self-powered display device (100) of any of claims 1-2, further comprising:
an optical adhesive layer (130) disposed between the solar module (110) and the display panel (120).

4. The self-powered display device (100) of any of claims 1-3, wherein the solar module (110) further comprises two substrates (114), and the two substrates (114) are respectively disposed on two surfaces (1111, 1112) of the polymer layer (111).

5. The self-powered display device of any of claims 1-4, further comprising:
a case (140) disposed on an outer periphery of the display panel (120);
wherein, a size of the case (140) is larger than an outer periphery of the solar module (110).

6. The self-powered display device (100) of any of claims 1-5, wherein the case (140) comprises a plurality of auxiliary solar cells (141), and the auxiliary solar cells (141) are electrically connected to each other and spaced apart in the case (140).

7. The self-powered display device (100) of any of claims 1-6, wherein an area of each of the auxiliary solar cells (141) is smaller than an area of each of the solar cells (112).

8. The self-powered display device (100) of any of claims 1-7, further comprising:
a maximum power point tracking controller (150) electrically connected to the solar module (110).

9. A self-powered display device (200), **characterized in** comprising:
a first solar module (210) having a first surface (S1) and a second surface (S2) opposite to each other, and comprising a plurality of opaque patterns (213);
a second solar module (220) disposed on the second surface (S2) of the first solar module (210), and having a third surface (S3) and a fourth surface (S4) opposite to each other, wherein the third surface (S3) is attached to the second surface (S2) of the first solar module (210); and
a display panel (230) disposed on the first surface (S1) of the first solar module (210);
wherein, the first solar module (210) is configured to receive the light from the first surface (S1), and the second solar module (220) is configured to receive the light from the fourth surface (S4), and each of the first solar module (210) or the second solar module (220) comprises:
a polymer layer (211, 221); and
a plurality of solar cells (212, 222) electrically connected to each other and embedded in the polymer layer (211, 221) at intervals;
wherein, the opaque patterns (213) of the first solar module (210) are embedded in the polymer layer (211, 221) of the first solar module (210), and projections of the opaque patterns (213) on the first surface (S1) are respectively located between projections of the solar cells (212, 222) on the first surface (S1).

10. The self-powered display device (200) of claim 9, wherein a surface of the opaque patterns (213) away from the solar cells (212, 222) is coplanar with a surface of the polymer layer (211, 221) adjacent to the first surface (S1).

11. The self-powered display device (200) of any of claims 9-10, further comprising:
an optical adhesive layer (240) disposed between the first solar module (210) and the display panel (230).

12. The self-powered display device (200) of any of claims 9-11, wherein each of the first solar module (210) or the second solar module (220) further comprises two substrates (214, 223), and the two substrates (214, 223) are respectively disposed on two surfaces of the polymer layer (211, 221).

13. The self-powered display device (200) of any of claims 9-12, further comprising:
a maximum power point tracking controller (260) electrically connected to the first solar module (210) and the second solar module (220); and
a switch (270) electrically connected to the first solar module (210), the second solar module (220) and the maximum power point tracking controller (260);
wherein, the maximum power point tracking controller (260) controls the switch (270) to switch according to light intensities or power outputs of the first solar module (210) and the second solar module (220).

14. The self-powered display device (200) of any of claims 9-13, wherein the maximum power point tracking controller (260) compares the light intensities or the power outputs of the first solar module (210) and the second solar module (220), and controls the switch (270) to switch to one with higher light intensity or higher power output to the maximum power point tracking controller (260).
